# EUROPEAN PATENT SPECIFICATION

(11) **EP 4 053 571 B1**
(45) Date of publication and mention of the grant of the patent: **18.02.2026**
(21) Application number: 20881213.1
(22) Date of filing: 30.10.2020
(51) Int. Cl.: G01R 31/12, H02H 1/00, H02H 3/50, G01R 31/52, G01R 31/54, H02H 3/027

(54) **ELECTRICAL DISCHARGE DETECTION SYSTEM**
ELEKTRISCHES ENTLADUNGSDETEKTIONSSYSTEM
SYSTÈME DE DÉTECTION DE DÉCHARGE ÉLECTRIQUE

(30) Priority: 01.11.2019 JP 2019199501
(43) Date of publication of application: 07.09.2022
(73) Proprietor: Nitto Kogyo Corporation, Nagakute-shi, Aichi 480-1189 (JP)
(72) Inventor: MIYAMOTO Atsushi, Nagakute-shi, Aichi 480-1189 (JP)
(74) Representative: Müller Schupfner & Partner Patent- und Rechtsanwaltspartnerschaft mbB (Muc)
(86) International application number: PCT/JP2020/040790
(87) International publication number: WO 2021/085594

(56) References cited:
- WO-A1-2017/022032
- WO-A1-2019/198791
- JP-A- 2001 242 212
- JP-A- 2016 223 821
- JP-A- 2018 185 223
- JP-A- 2019 184 479
- US-A1- 2010 157 488
- US-A1- 2016 181 799
- US-A1- 2019 285 683
- US-B1- 9 995 796

## Description

### Technical Field

The present invention relates to a discharge detection system.

### Background Art

Patent Document 1 discloses a system to detect high frequency noise generated by a discharge phenomenon using a CR circuit. The CR circuit is configured to connect a capacitor and a resistor in series and is electrically connected between different electrodes in a circuit. Such a CR circuit passes noise components at a predetermined frequency or more. Measurement of the value of the voltage applied to both ends of the resistor in the CR circuit allows detection of discharge phenomena.

Patent Document 2 relates to a discharge accident detection structure that determines whether or not a discharge accident has occurred based on the change between the current value before the discharge is detected and the current value after the discharge is detected.

Patent Document 3 relates to an arc fault type classifier that determines the arc fault type based on changes in current and/or voltage when an arc fault is detected.

Patent Document 4 relates to a DC power generation system that identifies the location of an arc based on the variation between the voltage-current operating point before the arc is detected and the voltage-current operating point after the arc is detected.

Patent Document 5 relates to a distribution board capable of detecting an abnormal discharge phenomenon occurring on the secondary side of multiple branch breakers with a single processor.

Patent Document 6 relates to an apparatus with a microcontroller that generates a trip signal to interrupt an operation of an electrical circuit based on a secondary signal that has passed through a high-pass filter.

### Prior Art Documents

### Patent Document

Patent Document 1: JP 2017-173008 A
Patent Document 2: JP 2019-184479 A
Patent Document 3: US 9,995,796 B1
Patent Document 4: US 2016/181799 A1
Patent Document 5: WO 2019/198791 A1
Patent Document 6: US 2010/157488 A1

Discharge phenomena occur by causes such as disconnection and a short circuit, for example. Although being capable of detecting a discharge phenomenon, the system in the past described above is not capable of specifying the cause of the discharge phenomenon. Users of the system thus have to specify the cause of the discharge phenomenon by examining the states of indoor wiring, electrical appliances, plugs, plug sockets, and the like after the discharge phenomenon is detected.

### Disclosure of the Invention

### Problems to be solved by the Invention

The present invention has been made in view of the above problems and it is an object thereof to provide a discharge detection system that is capable of specifying information on a detected discharge phenomenon and is capable of facilitating specification of the cause of the discharge phenomenon by a user.

### Means to solve the Problems

(1) To achieve the above object, a discharge detection system of the present invention includes: a current detection section configured to detect a value of current flowing in a circuit; a high pass filter configured to detect noise in a high frequency band superimposed on the circuit by a discharge phenomenon; and a determination section electrically connected to the current detection section and the high pass filter, wherein the determination section executes process including determining whether the discharge phenomenon has occurred based on the noise in the high frequency band detected by the high pass filter, when the discharge phenomenon is determined to have occurred, calculating an increase or decrease in the current value at the occurrence of the discharge phenomenon based on the current value detected by the current detection section, and specifying information on the discharge phenomenon based on the increase or decrease in the current value.
(2) It is preferred that, in the discharge detection system according to (1) above, a plurality of time periods are set in accordance with magnitude of the current value, the determination section executes, when the discharge phenomenon is determined to have occurred, process to output a cutoff signal after the time period has passed set in accordance with the magnitude of the current value at the occurrence of the discharge phenomenon, and a switch electrically connected to the circuit turns into an open state based on the cutoff signal to interrupt power supply to the circuit.
(3) It is preferred that, in the discharge detection system according to (1) or (2) above, the high pass filter is electrically connected to the determination section via first wiring, the current detection section is electrically connected to the determination section via second wiring, and the determination section determines whether the discharge phenomenon has occurred based on the noise in the high frequency band input via the first wiring and calculates the increase or decrease in the current value at the occurrence of the discharge phenomenon based on the current value input via the second wiring.

In the discharge detection system according to any of (1) through (3) above, the determination section executes process including: specifying the discharge phenomenon to have occurred between different electrodes when the current value at the occurrence of the discharge phenomenon increases; and specifying the discharge phenomenon to have occurred between identical electrodes when the current value at the occurrence of the discharge phenomenon decreases.

### Effects of the Invention

The discharge detection system of the present invention is capable of specifying information on a detected discharge phenomenon based on an increase or decrease in the current value at the occurrence of the discharge phenomenon. The information facilitates specification of the cause of the discharge phenomenon by a user.

### Brief Description of the Drawings

Fig. 1 is a circuit diagram illustrating a breaker provided with a discharge detection system according to a first embodiment of the present invention.
Fig. 2A is a diagram illustrating the waveform of current detected by a current detection section. Fig. 2B is a diagram illustrating the waveform of current passing through a high pass filter.
Fig. 3A is a schematic diagram illustrating the state in which a plug of a load is electrically connected to a plug socket. Fig. 3B is a circuit diagram omitting the plug and the plug socket in Fig. 3A.
Fig. 4A is a schematic diagram illustrating the state in which disconnection occurs between the load and the plug. Fig. 4B is a circuit diagram omitting the plug and the plug socket in Fig. 4A.
Fig. 5 is a diagram illustrating the waveform of current detected by the current detection section while instantaneous disconnection as illustrated in Fig. 4A occurs a plurality of times.
Fig. 6A is a schematic diagram illustrating the state in which a small short circuit occurs near the plug. Fig. 6B is a circuit diagram omitting the plug and the plug socket in Fig. 6A.
Fig. 7 is a diagram illustrating the waveform of current detected by the current detection section while small short circuits as illustrated in Fig. 5 instantaneously occur a plurality of times.
Fig. 8 is a circuit diagram illustrating a breaker provided with a discharge detection system according to a second embodiment of the present invention.
Fig. 9 is a circuit diagram illustrating a discharge detection system according to a third embodiment of the present invention and a breaker provided separately from the discharge detection system.

### Modes for Carrying Out the Invention

### 1. First Embodiment

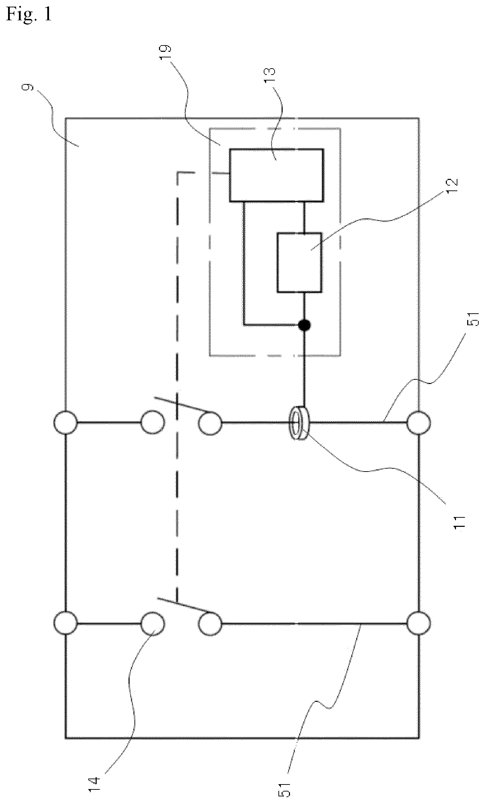

At first, with reference to Figs.1 through 7, a description is given to a discharge detection system according to the first embodiment of the present invention.

A breaker 9 illustrated in Fig. 1 is provided with a discharge detection system 19 in the present embodiment. The breaker 9 is electrically connected to, for example, indoor wiring of a building. The power provided by a power company is supplied to lighting fixtures, plug sockets, and the like provided in the building via the breaker 9. The breaker 9 is provided with switches 14. The switches 14 turn into an open state when current greater than a given value flows in the breaker 9 to interrupt the power supply to the indoor wiring. In this situation, the switches 14 in the present embodiment turn into an open state based on a cutoff signal output from the discharge detection system 19. This issue is detailed later.

The discharge detection system 19 in the present embodiment is configured with a current detection section 11, a high pass filter 12, and a determination section 13.

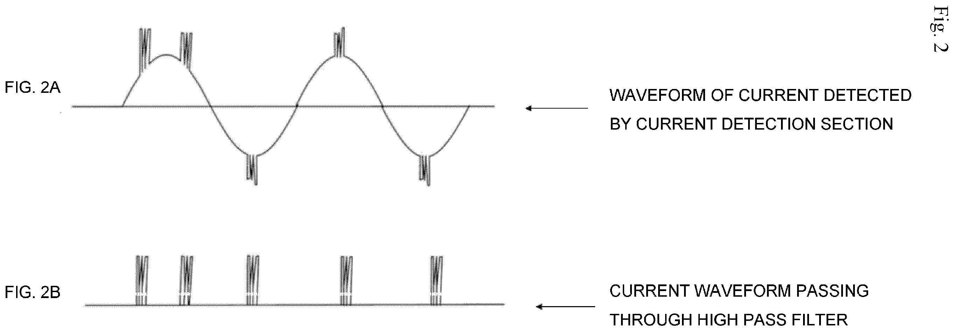

The current detection section 11 detects current flowing in wiring 51 of the breaker 9. The current detection section 11 is, for example, a current transformer and has a configuration of winding a secondary winding on an annular core. Through the annular core, the wiring 51 subjected to the current measurement passes. The secondary winding feeds secondary current in proportion to primary current flowing in the primary wiring. Fig. 2A illustrates the waveform of the current detected by the current detection section 11.

The high pass filter 12 is electrically connected to the current detection section 11 and the determination section 13. The high pass filter 12 passes noise in a frequency band higher than a cutoff frequency generated in an alternating circuit. When a discharge phenomenon occurs, the noise in the higher frequency band is superimposed on output from the current detection section 11. The high pass filter 12 detects the noise in the higher frequency band for output to the determination section 13. Fig. 2B illustrates the waveform of the current passing through the high pass filter 12.

The determination section 13 is electrically connected to the current detection section 11 and the high pass filter 12. To the determination section 13, the current detected by the current detection section 11 and the noise in the higher frequency band having passed through the high pass filter 12 are input. In the present embodiment, the wiring electrically connecting the current detection section 11 with the high pass filter 12 is branched in the middle to directly input the current detected by the current detection section 11 to the determination section 13.

The determination section 13 determines whether a discharge phenomenon has occurred based on the noise in the higher frequency band having passed through the high pass filter 12. For example, the determination section 13 determines that a discharge phenomenon has occurred if the noise in the higher frequency band having passed through the high pass filter 12 is greater than a predetermined threshold during a predetermined time period.

Meanwhile, the determination section 13 calculates an increase or decrease in the value of the current detected by the current detection section 11 at the timing the discharge phenomenon occurs. The determination section 13 then specifies information on the detected discharge phenomenon based on the increase or decrease in the current value. The information facilitates specification of the cause of the discharge phenomenon by a user.

Here, the technical significance of combining the current detection section 11 with the high pass filter 12 is described.

In the first place, the combination of the current detection section 11 with the high pass filter 12 allows detection of occurrence of a discharge phenomenon. That is, in the wiring 51, alternating current flows. The alternating current originally has a waveform of a regular sine wave. If a discharge phenomenon occurs, noise in the higher frequency band is superimposed on the alternating current, resulting in irregular sine waves of the alternating current. It is thus considered that monitoring of the waveform of the current detected by the current detection section 11 allows detection of occurrence of a discharge phenomenon.

However, various electrical appliances (load 62) are connected to the indoor wiring of the building. Noise is also generated when the load 62 is switched ON/OFF. The noise is also superimposed on the alternating current flowing in the wiring 51, causing an irregular sine wave of the alternating current. It is thus not possible to detect occurrence of a discharge phenomenon only by monitoring the waveform of the current detected by the current detection section 11. Accordingly, in the present embodiment, results of detection by the current detection section 11 are filtered with the high pass filter 12 to select only noise in the higher frequency band caused by discharge phenomena. It is thus possible to detect occurrence of such a discharge phenomenon.

In the second place, combination of the current detection section 11 with the high pass filter 12 allows specification of information on the detected discharge phenomenon. That is, the information on the detected discharge phenomenon is specified based on an increase or decrease in the current value at the timing the discharge phenomenon occurs. As illustrated in Figs. 2A and 2B, the timing the discharge phenomenon occurs is equal to the timing the high pass filter 12 detects the noise in the higher frequency band. It is thus possible to determine the cause of the discharge phenomenon by calculating an increase or decrease in the current value at the timing the high pass filter 12 detects the noise in the higher frequency band. Moreover, it is possible to estimate the degree of danger of the discharge phenomenon based on the magnitude of the current value at the timing the discharge phenomenon occurs.

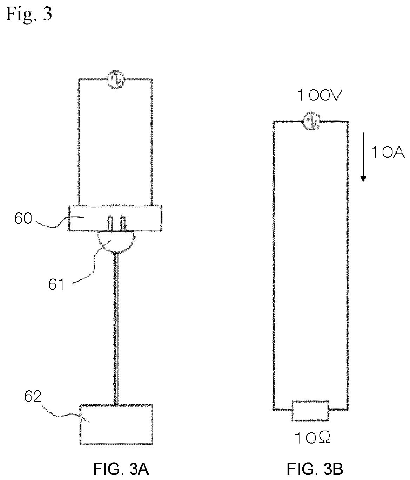

The information on the detected discharge phenomenon includes, for example, the type and cause of the discharge phenomenon. With reference to Figs. 3A through 7, the types and causes of discharge phenomena are described. There are two types of discharge phenomena: discharge phenomena occurring between identical electrodes and discharge phenomena occurring between different electrodes.

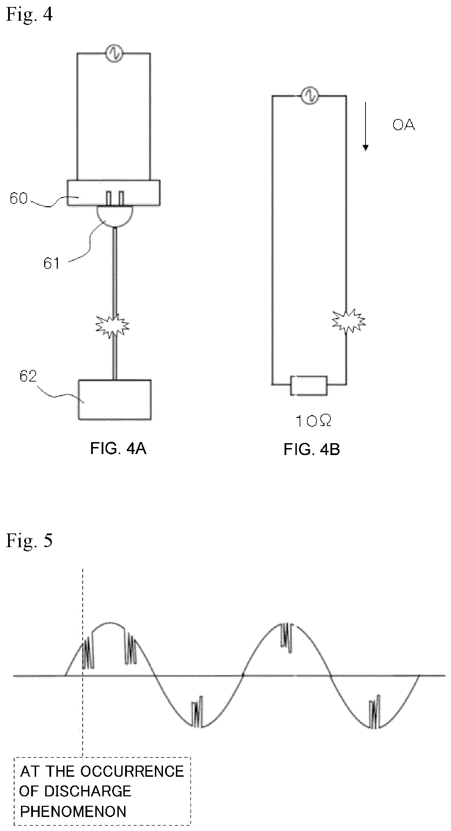

At first, the discharge phenomena occurring between identical electrodes are described. Figs. 3A and 3B illustrate the state in which a plug 61 of the load 62 is electrically connected to a plug socket 60. Figs. 4A and 4B illustrate the state in which disconnection occurs between the load 62 and the plug 61. The cause of the discharge phenomena occurring between identical electrodes is disconnection. If disconnection occurs, current is less likely to flow. As illustrated in the current waveform of Fig. 5, the current value at the occurrence of a discharge phenomenon between identical electrodes thus decreases from the current value before the occurrence of the discharge phenomenon. The current waveform has concave irregularities partially in the sine wave.

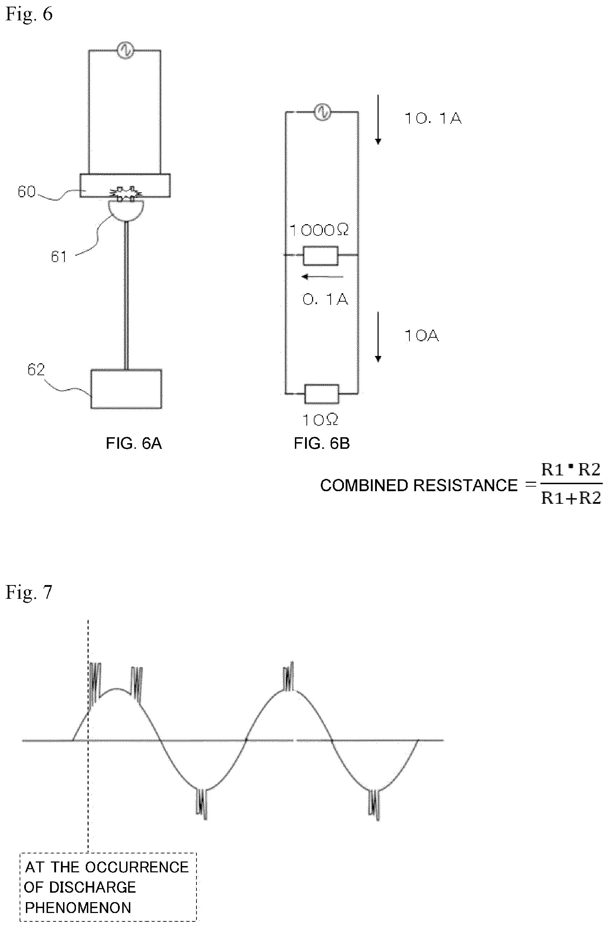

Then, the discharge phenomena occurring between different electrodes are described. Figs. 6A and 6B illustrate the state in which a small short circuit occurs near the plug 61. The cause of the discharge phenomena occurring between different electrodes is a short circuit. If a short circuit occurs, current is likely to flow. As illustrated in the current waveform of Fig. 7, the current value at the occurrence of the discharge phenomenon between different electrodes thus increases from the current value before the occurrence of the discharge phenomenon. The current waveform has convex irregularities partially in the sine wave.

As just described, it is possible to specify the type and cause of the discharge phenomenon based on the increase or decrease in the current value at the timing the discharge phenomenon occurs. More specifically, the determination section 13 illustrated in Fig. 1 specifies, when the current value increases at the timing a discharge phenomenon occurs, the discharge phenomenon to have occurred between different electrodes and specifies, when the current value decreases at that timing, the discharge phenomenon to have occurred between identical electrodes. The discharge phenomenon between different electrodes means that a short circuit has occurred. The discharge phenomenon between identical electrodes means that disconnection has occurred. A user can readily draw the cause of the discharge phenomenon by being provided with information on whether the detected discharge phenomenon has occurred between different electrodes or between identical electrodes.

In this situation, when a discharge phenomenon is determined to have occurred, the determination section 13 outputs a cutoff signal. The cutoff signal is input to a mechanical section of each switch 14 electrically connected to the wiring 51. The mechanical section causes the switch 14 to operate and turn into an open state based on the cutoff signal. The power supply to the indoor wiring is thus interrupted.

The determination section 13 may perform process of varying the timing of outputting a cutoff signal in accordance with the magnitude of the current value at the timing a discharge phenomenon occurs. As described above, the magnitude of the current value at the timing the discharge phenomenon occurs indicates the degree of danger of the discharge phenomenon. It is considered that a larger current value indicates that the discharge phenomenon is more dangerous and a smaller current value indicates that the discharge phenomenon is less dangerous. Accordingly, a larger current value causes the determination section 13 to output a cutoff signal in a shorter period of time after the occurrence of the discharge phenomenon, and a smaller current value causes the determination section 13 to output a cutoff signal in a longer period of time after the occurrence of the discharge phenomenon. This causes the switches 14 to be in an open state at a timing in accordance with the degree of danger of the discharge phenomenon. In other words, if the discharge phenomenon is more dangerous, the breaker 9 is quickly interrupted. In contrast, if the discharge phenomenon is less dangerous, the breaker 9 is interrupted with delay.

The determination section 13 measures the magnitude of the current value at the timing the discharge phenomenon occurs based on the result of detection by either the current detection section 11 or the high pass filter 12. The current value may be either an effective value or an average value. For example, the current value at the timing a discharge phenomenon occurs is assumed as 5 A, 10 A, 16 A, or 32 A. In the case of 5 A, a cutoff signal is output 1 second after the discharge phenomenon occurred. In the case of 10 A, a cutoff signal is output 0.4 seconds after the discharge phenomenon occurred. In the case of 16 A, a cutoff signal is output 0.28 seconds after the discharge phenomenon occurred. In the case of 32 A, a cutoff signal is output 0.14 seconds after the discharge phenomenon occurred. In the case of 32 A or more, a cutoff signal may be output uniformly 0.14 seconds after the discharge phenomenon occurred. As another example, in the case of greater than 32 A, a cutoff signal may be output in a period of time shorter than 0.14 seconds in accordance with the current value. It should be noted that the relationship between the magnitude of the current value and the time period before a cutoff signal is output is not particularly limited.

### 2. Second Embodiment

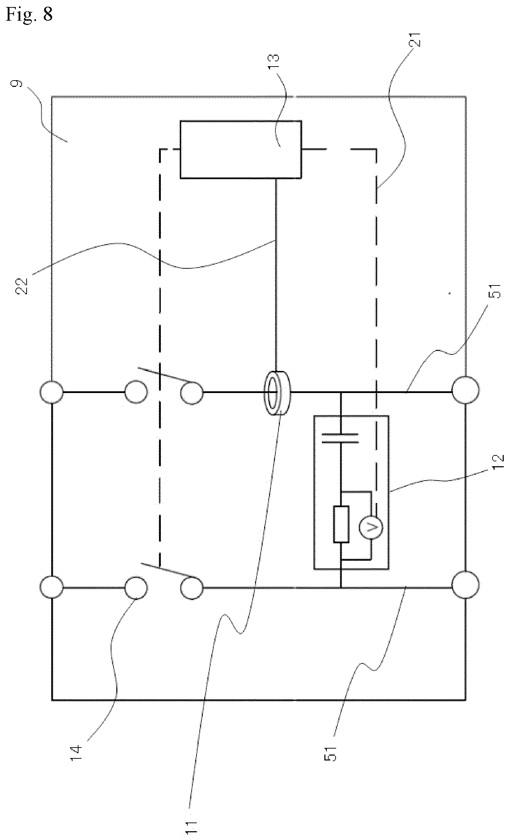

Fig. 8 illustrates a breaker 9 provided with a discharge detection system according to the second embodiment of the present invention. The discharge detection system 19 in the first embodiment illustrated in Fig. 1 is configured to electrically connect the high pass filter 12 to the current detection section 11. In contrast, the discharge detection system in the second embodiment illustrated in Fig. 8 is configured to electrically connect the high pass filter 12 between the wiring 51 of the different electrodes.

As illustrated in Fig. 8, the high pass filter 12 is electrically connected to the determination section 13 via first wiring 21. Noise in a higher frequency band detected by the high pass filter 12 is input to the determination section 13 via the first wiring 21. Meanwhile, the current detection section 11 is electrically connected to the determination section 13 via second wiring 22. The waveform of current detected by the current detection section 11 is input to the determination section 13 via the second wiring 22.

As just described, in the discharge detection system of the second embodiment, the high pass filter 12 is electrically connected to the determination section 13 separately from the current detection section 11. The determination section 13 determines whether a discharge phenomenon has occurred based on the result of detection by the high pass filter 12 input from the first wiring 21. The determination section 13 also determines an increase or decrease in the current value based on the result of detection by the current detection section 11 input from the second wiring 22. The first wiring 21 and the second wiring 22 are independent of each other and the result of detection by the high pass filter 12 is not influenced by the result of detection by the current detection section 11. It should be noted that the high pass filter 12 may be configured to be electrically connected to the primary side of the current detection section 11 in the wiring 51.

### 3. Third Embodiment

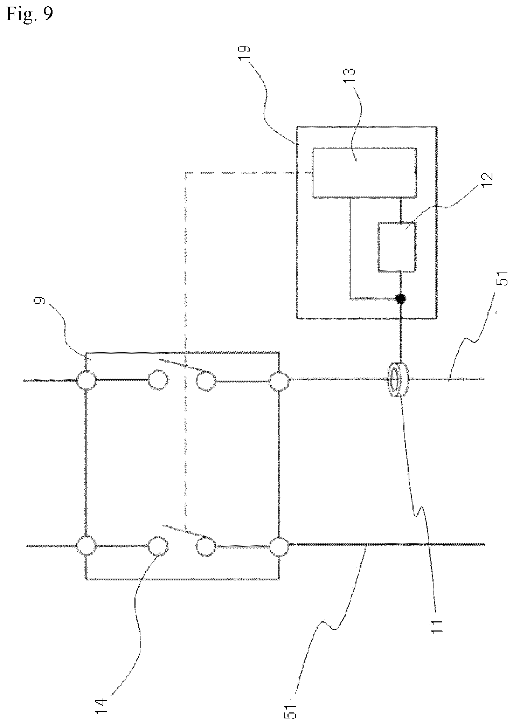

Fig. 9 illustrates a discharge detection system 19 according to the third embodiment of the present invention and a breaker 9 provided separately from the discharge detection system 19. Both discharge detection systems in the first and second embodiments illustrated in Figs. 1 and 8 are provided in the breaker 9. In contrast, the discharge detection system 19 in the third embodiment illustrated in Fig. 9 may be an independent apparatus provided separately from the breaker 9.

The discharge detection system of the present invention is not limited to the configuration in the first through third embodiments described above and the configuration may be variously altered. For example, the current detection section 11 illustrated in Figs. 1 or 9 may be included in the unit of the discharge detection system 19 together with the high pass filter 12 and the determination section 13.

### Description of Reference Numerals

- 9: Breaker
- 11: Current Detection Section
- 12: High Pass Filter
- 13: Determination Section
- 14: Switch
- 19: Discharge Detection System
- 21: First Wiring
- 22: Second Wiring
- 51: Wiring

## Claims

1. A discharge detection system comprising:
a current detection section (11) configured to detect a value of current flowing in a circuit;
a high pass filter (12) configured to detect noise in a high frequency band superimposed on the circuit by a discharge phenomenon; and
a determination section (13) electrically connected to the current detection section (11) and the high pass filter (12), wherein
the determination section (13) is configured to execute a process including
determining whether the discharge phenomenon has occurred based on the noise in the high frequency band detected by the high pass filter (12),
when the discharge phenomenon is determined to have occurred, calculating an increase or decrease in the current value at the occurrence of the discharge phenomenon based on the current value detected by the current detection section (11), **characterized in that**:
the process further includes
specifying the discharge phenomenon to have occurred between different electrodes when the current value at the occurrence of the discharge phenomenon increases, and
specifying the discharge phenomenon to have occurred between identical electrodes when the current value at the occurrence of the discharge phenomenon decreases.

2. The discharge detection system according to Claim 1, wherein
a plurality of time periods are set in accordance with magnitude of the current value,
the determination section (13) is configured to execute, when the discharge phenomenon is determined to have occurred, process to output a cutoff signal after the time period has passed set in accordance with the magnitude of the current value at the occurrence of the discharge phenomenon, and
a switch (14) electrically connected to the circuit turns into an open state based on the cutoff signal to interrupt power supply to the circuit.

3. The discharge detection system according to Claim 1 or 2, wherein
the high pass filter (12) is electrically connected to the determination section (13) via first wiring,
the current detection section (11) is electrically connected to the determination section (13) via second wiring, and
the determination section (13) is configured to determine whether the discharge phenomenon has occurred based on the noise in the high frequency band input via the first wiring and configured to calculate the increase or decrease in the current value at the occurrence of the discharge phenomenon based on the current value input via the second wiring.

## Patentansprüche

1. Ein Entladungserkennungssystem, umfassend:
einen Stromerfassungsabschnitt (11), der so konfiguriert ist, dass er einen Wert des in einem Stromkreis fließenden Stroms erkennt;
ein Hochpassfilter (12), das so konfiguriert ist, dass es Rauschen in einem Hochfrequenzband erkennt, das durch ein Entladungsphänomen dem Stromkreis überlagert wird; und
einen Bestimmungsabschnitt (13), der elektrisch mit dem Stromerfassungsabschnitt (11) und dem Hochpassfilter (12) verbunden ist, wobei
der Bestimmungsabschnitt (13) so konfiguriert ist, dass er einen Prozess ausführt, umfassend
Bestimmen, ob das Entladungsphänomen aufgetreten ist, basierend auf dem vom Hochpassfilter (12) erfassten Rauschen im Hochfrequenzband,
wenn festgestellt wird, dass das Entladungsphänomen aufgetreten ist, Berechnen einer Zunahme oder Abnahme des Stromwerts beim Auftreten des Entladungsphänomens auf der Grundlage des vom Stromerfassungsabschnitt (11) erfassten Stromwerts, **dadurch gekennzeichnet, dass**
der Prozess ferner umfasst
Festlegen, dass das Entladungsphänomen zwischen verschiedenen Elektroden aufgetreten ist, wenn der Stromwert beim Auftreten des Entladungsphänomens zunimmt, und
Festlegen, dass das Entladungsphänomen zwischen identischen Elektroden aufgetreten ist, wenn der Stromwert beim Auftreten des Entladungsphänomens abnimmt.

2. Entladungserkennungssystem nach Anspruch 1, wobei
eine Vielzahl von Zeiträumen entsprechend der Größe des Stromwerts festgelegt wird,
der Bestimmungsabschnitt (13) so konfiguriert ist, dass er, wenn festgestellt wird, dass das Entladungsphänomen aufgetreten ist, einen Prozess ausführt, um ein Abschaltsignal auszugeben, nachdem die Zeitdauer abgelaufen ist, die entsprechend der Größe des Stromwerts beim Auftreten des Entladungsphänomens festgelegt wurde, und
ein mit dem Strokreis elektrisch verbundener Schalter (14) auf der Grundlage des Abschaltsignals in einen offenen Zustand übergeht, um die Stromversorgung des Stromkreises zu unterbrechen.

3. Entladungserkennungssystem nach Anspruch 1 oder 2, wobei
das Hochpassfilter (12) über eine erste Verdrahtung elektrisch mit dem Bestimmungsabschnitt (13) verbunden ist,
der Stromerfassungsabschnitt (11) über eine zweite Verdrahtung elektrisch mit dem Bestimmungsabschnitt (13) verbunden ist und
der Bestimmungsabschnitt (13) so konfiguriert ist, dass er auf der Grundlage des über die erste Verdrahtung eingegebenen Rauschens im Hochfrequenzband bestimmt, ob das Entladungsphänomen aufgetreten ist, und so konfiguriert ist, dass er auf der Grundlage des über die zweite Verdrahtung eingegebenen Stromwerts die Zunahme oder Abnahme des Stromwerts beim Auftreten des Entladungsphänomens berechnet.

## Revendications

1. Système de détection de décharge comprenant :
une section de détection de courant (11) configurée pour détecter une valeur d'un courant s'écoulant dans un circuit ;
un filtre passe-haut (12) configuré pour détecter un bruit dans une bande à haute fréquence en superposition sur le circuit via un phénomène de décharge ; et
une section de détermination (13) connectée électriquement à la section de détection de courant (11) et au filtre passe-haut (12), dans lequel
la section de détermination (13) est configurée pour exécuter un processus incluant de
déterminer si le phénomène de décharge s'est produit sur la base du bruit dans la bande à haute fréquence détecté par le filtre passe-haut (12),
quand le phénomène de décharge est déterminé comme s'étant produit, calculer une augmentation ou une diminution dans la valeur de courant lorsque le phénomène de décharge se produit sur la base de la valeur de courant détectée par la section de détection de courant (11),
**caractérisé en ce que** :
le processus inclut en outre de
spécifier le phénomène de décharge comme s'étant produit entre différentes électrodes quand la valeur de courant, lorsque le phénomène de décharge se produit, augmente, et
spécifier le phénomène de décharge comme s'étant produit entre des électrodes identiques quand la valeur de courant, lorsque le phénomène de décharge se produit, diminue.

2. Système de détection de décharge selon la revendication 1, dans lequel
une pluralité de périodes temporelles sont définies en accord avec une intensité de la valeur de courant,
la section de détermination (13) est configurée pour exécuter, quand le phénomène de décharge est déterminé comme s'étant produit, un processus pour sortir un signal de coupure après écoulement de la période temporelle définie en accord avec l'intensité de la valeur de courant lorsque le phénomène de décharge se produit, et
un commutateur (14) connecté électriquement au circuit passe dans un état ouvert sur la base du signal de coupure pour interrompre une alimentation de puissance au circuit.

3. Système de détection de décharge selon la revendication 1 ou 2, dans lequel
le filtre passe-haut (12) est connecté électriquement à la section de détermination (13) via un premier câblage,
la section de détection de courant (11) est connectée électriquement à la section de détermination (13) via un second câblage, et
la section de détermination (13) est configurée pour déterminer si le phénomène de décharge s'est produit sur la base du bruit dans la bande à haute fréquence entré via le premier câblage, et est configurée pour calculer l'augmentation ou la diminution dans la valeur de courant lorsque le phénomène de décharge se produit sur la base de la valeur de courant entrée via le second câblage.
